# EUROPÄISCHE PATENTSCHRIFT

(11) **EP 0 509 124 B1**
(45) Veröffentlichungstag und Bekanntmachung des Hinweises auf die Patenterteilung: **27.03.1996**
(21) Anmeldenummer: 91106336.0
(22) Anmeldetag: 19.04.1991
(51) Int. Cl.: H03C 3/00, H03B 5/12

(54) **Oszillatorschaltung**
Oscillator circuit
Circuit oscillateur

(43) Veröffentlichungstag der Anmeldung: 21.10.1992
(73) Patentinhaber: SIEMENS AKTIENGESELLSCHAFT, D-80333 München (DE)
(72) Erfinder: Fenk, Joseph, Dipl.-Ing., W-8057 Eching/Offenburg (DE)

(56) Entgegenhaltungen:
- EP-A- 0 141 933
- EP-A- 0 388 890
- DE-A- 2 131 159
- DE-A- 2 649 745
- DE-A- 3 405 550
- GB-A- 2 120 879

## Beschreibung

Die Erfindung betrifft eine Oszillatorschaltung.

Insbesondere für Anwendungen im Mobilfunkbereich sowie auf dem Gebiet der Rundfunk- und Fernsehtechnik werden häufig frequenzmodulierbare Oszillatorschaltungen mit hoher Frequenzkonstanz und kleiner Schwingungsamplitude benötigt. Eine hierfür bevorzugt eingesetzte Oszillatorschaltung ist beispielsweise aus der europäischen Patentschrift 0141933 bekannt. Bei dieser Oszillatorschaltung liegen die Fußpunkte von drei Konstantstromquellen am Anschluß für ein Bezugspotential. Dabei ist der Ausgang der ersten Konstantstromquelle mit dem Emitter eines ersten Transistors und mit der Basis eines zweiten Transistors sowie der Ausgang der zweiten Konstantstromquelle mit dem Emitter eines dritten Transistors und der Basis eines vierten Transistors verbunden. Der Emitter des zweiten Transistors und der Emitter des vierten Transistors liegen am Ausgang der dritten Konstantstromquelle. Weiterhin liegt der Kollektor des ersten Transistors und der Kollektor des dritten Transistors unmittelbar am Anschluß für das Versorgungspotential, während der Kollektor des zweiten Transistors und der Kollektor des vierten Transistors unter Vermittlung je eines Widerstands an den Anschluß für das Versorgungspotential angeschlossen sind. Außerdem ist die Basis des ersten Transistors über einen Widerstand mit dem Kollektor des vierten Transistors und die Basis des dritten Transistors über einen weiteren Widerstand mit dem Kollektor des zweiten Transistors verbunden. Zwischen der Basis des dritten Transistors und der Basis des ersten Transistors ist ein frequenzbestimmendes Rückkopplungsglied, z. B. ein Schwingkreis, eingefügt. Die gelieferte Oszillatorspannung ist zwischen dem Emitter des ersten Transistors und dem Emitter des dritten Transistors abnehmbar. Das Oszillatorsignal wird mit Hilfe von Kaskodentransistoren geliefert, in dem ein erster Kaskodentransistor mit seinem Emitter an dem vom zweiten Transistor abgewandten Ende des zum ersten Transistor gehörenden Lastwiderstands und ein Kaskodentransistor mit seinem Emitter an dem vom vierten Transistor abgewandten Ende des zum vierten Transistor gehörenden Lastwiderstands angeschlossen ist und auf diese Weise die einzige Verbindung zwischen dem Lastwiderstand und dem Anschluß für das Versorgungspotential gegeben ist, indem die Basisanschlüsse der beiden Kaskodentransistoren mit einem gemeinsamen Referenzpotential und der Kollektor der beiden Kaskodentransistoren unter Verwendung je eines Widerstands mit dem Anschluß für das Versorgungspotential verbunden ist, so daß zwischen den Kollektoren der beiden Kaskodentransistoren das abzunehmende Oszillatorsignal entsteht.

Die Verbindung zwischen dem Emitter des zweiten Transistors und des vierten Transistors zum Ausgang der dritten Konstantstromquelle erfolgt unter Vermittlung eines fünften Transistors, dessen Emitter am Ausgang der Konstantstromquelle liegt und dessen Kollektor mit den Emittern des zweiten Transistors und des vierten Transistors verbunden ist. Außerdem liegt der Emitter des fünften Transistors über einen fünften Widerstand einerseits am Emitter eines sechsten Transistors und andererseits am Ausgang einer mit ihrem Fußpunkt am Bezugspotential liegenden vierten Konstantstromquelle. Ferner ist ein durch ein NF-Signal zu beaufschlagender durch die Basis eines siebten Transistors und ein durch eine Referenzspannung zu beauschlagender achter Eingang durch die Basis eines achten Transistors gegeben. Dabei liegt der Emitter des siebten Transistors am Ausgang einer an den Anschluß für das Bezugspotential mit ihrem Fußpunkt angeschlossenen fünften Konstantstromquelle und der Emitter des achten Transistors am Ausgang einer an den Anschluß für das Bezugspotential mit ihrem Fußpunkt angeschlossenen sechsten Konstantstromquelle. Weiterhin ist der Emitter des siebten Transistors mit der Basis des fünften Transistors sowie der Emitter des achten Transistors mit der Basis des sechsten Transistors verbunden. Der Kollektor des siebten Transistors sowie der Kollektor des achten Transistors liegen unmittelbar am Anschluß für das Versorgungspotential, während der Kollektor des sechsten Transistors unmittelbar am Emitter eines neunten Transistors und am Emitter des zehnten Transistors liegt. Außerdem ist der Kollektor des neunten Transistors und der Kollektor des zehnten Transistors über je einen Lastwiderstand am Anschluß für das Versorgungspotential angeschlossen. Der Kollektor des neunten Transistors schließlich ist über einen weiteren Widerstand mit der Basis des dritten Transistors sowie der Kollektor des zehnten Transistors über einen weiteren Widerstand mit der Basis des ersten Transistors verbunden. Zwischen dem Kollektor des neunten Transistors und dem Kollektor des zehnten Transistors ist eine durch wenigstens einen Kondensator gegebene kapazitive Verbindung und zwischen den Kollektoren des zweiten Transistors und des vierten Transistors eine durch einen weiteren Widerstand gegebene Verbindung vorgesehen.

Nachteilig ist bei der bekannten Oszillatorschaltung, daß relativ hohe Betriebsspannungen benötigt werden.

Aufgabe der Erfindung ist es daher, eine frequenzmodulierbare Oszillatorschaltung anzugeben, die auch bei geringeren Betriebsspannungen arbeitet.

Diese Aufgabe wird durch eine Oszillatorschaltung gemäß Patentanspruch 1 gelöst. Ausgestaltungen und Weiterbildungen des Erfindungsgedankens sind Gegenstand von Unteransprüchen.

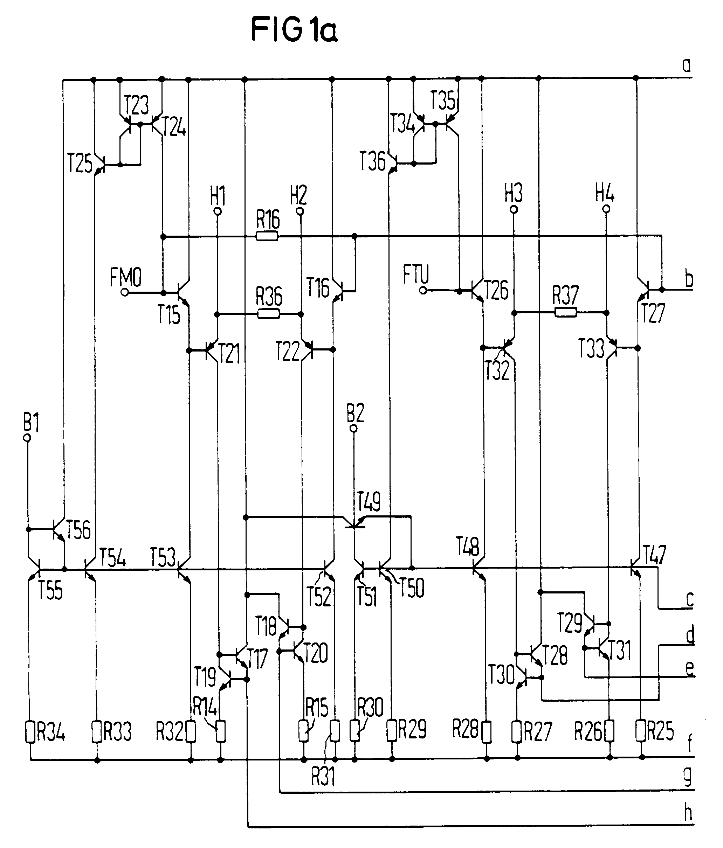

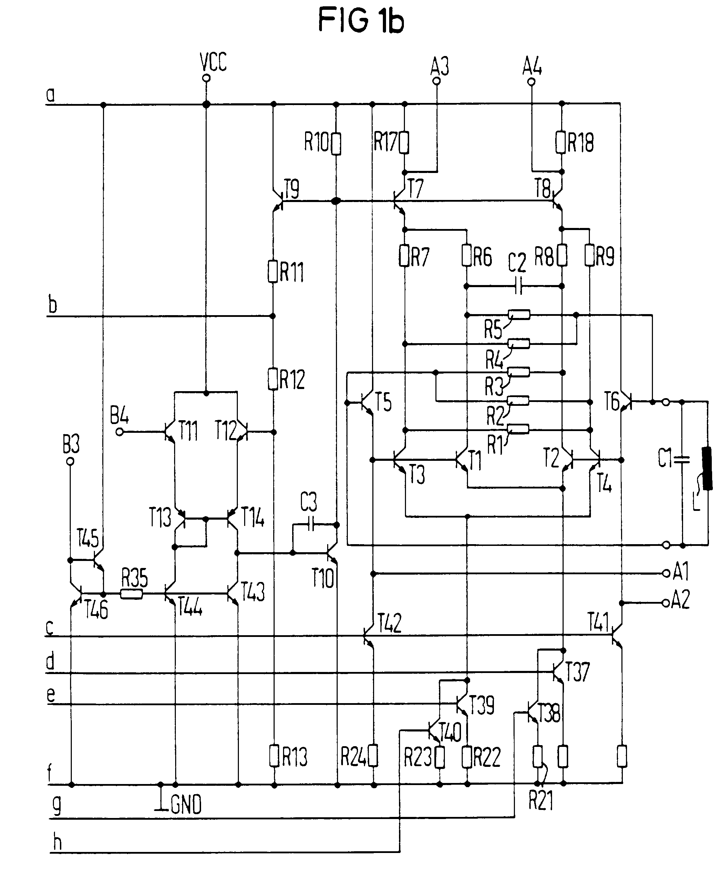

Die Erfindung wird nachfolgend anhand des in der einzigen Figur der Zeichnung dargestellten Ausführungsbeispiels näher erläutert.Zur Einhaltung von Formerfordernissen ist die einzige Figur entlang gekennzeichneter Schnittpunkte a bis h in zwei-Teilfiguren 1a und 1b aufgespalten.

Die als Ausführungsbeispiel gezeigte erfindungsgemäße Oszillatorschaltung besteht aus einer Oszillatorstufe und zwei Ansteuerstufen.Die Oszillatorstufe enthält ihrerseits zwei emittergekoppelte npn-Transistoren T1 und T2 sowie zwei emittergekoppeltete npn-Transistoren T3 und T4. Der Emitter eines npn-Transistors T5 ist mit den gekoppelten Basen der Transistoren T1 und T2 verbunden. Sein Kollektor ist an ein positives Versorgungspotential VCC angeschlossen, während seine Basis als Anschluß für ein frequenzbestimmendes Rückkopplungsglied - im vorliegenden Ausführungsbeispiel ist dies ein Schwingkreis bestehend aus einer Spule L und einem Kondensator C1 - vorgesehen ist. Ein npn-Transistor T6 ist über seinen Emitter mit den gekoppelten Basen der Transistoren T3 und T4 und über seinen Kollektor mit dem positiven Versorgungspotential VCC verbunden. Seine Basis ist als weiterer Anschluß für den Schwingkreis vorgesehen. Zwischen die Kollektoren der Transistoren T3 und T4, zwischen die Basis des Transistors T5 und den Kollektor des Transistors T4, zwischen die Basis des Transistors T5 und den Kollektor des Transistors T2, zwischen die Basis des Transistors T6 und den Kollektor des Transistors T3 sowie zwischen die Basis des Transistors T6 und den Kollektor des Transistors T1 sind jeweils Widerstände R1 bis R5 geschaltet. Außerdem sind zwei npn-Transistoren T7 und T8 vorgesehen, deren Kollektoren mit dem positiven Versorgungspotential VCC verbunden sind. Widerstände R6 und R7 verbinden den Emitter des Transistors T7 und die Kollektoren der Transistoren T1 und T3 und Widerstände R8 und R9 verbinden den Emitter des Transistors T8 und die Kollektoren der Transistoren T2 und T4. Ein negatives Versorgungspotential GND und die Emitter der Transistoren T5 und T6 sind über jeweils eine Stromquelle miteinander verschaltet. Dazu ist jeweils ein npn-Transistor T42 bzw. T41 emitterseitig über jeweils einem Widerstand R24 bzw. R19 mit dem negativen Versorgungspotential GND und kollektorseitig mit dem Emitter des Transistors T5 bzw. T6 verbunden.

Ein npn-Transistor T9 ist über seinen Kollektor mit dem positiven Versorgungspotential VCC und über seine Basis mit den Basen der Transistoren T7 und T8 verschaltet. Ein Widerstand R10 ist dabei zwischen das positive Versorgungspotential VCC und die Basis des Transistors T9 gelegt. Der Kollektor eines npn-Transistors T10 ist mit der Basis des Transistors T9 verbunden, während sein Emitter an das negative Versorgungspotential GND angeschlossen ist. Zwischen den Emitter des Transistors T9 und das negative Versorgungspotential sind drei Widerstände R11, R12 und R13 in Reihe geschaltet. Zwei emittergekoppelte npn-Transistoren T11 und T12 sind über ihre Kollektoren mit dem positiven Versorgungspotential VCC und über ihre Basen an ein Biaspotential B4 bzw.an einen Abgriff zwischen dem Widerstand R12 und dem Widerstand R13 angeschlossen. Zudem sind zwei pnp-Transistoren T13 und T14 vorgesehen, deren Emitter jeweils mit den Emittern der Transistoren T11 und T12 und deren Kollektoren über jeweils eine Stromquelle mit dem negativen Versorgungspotential GND verbunden sind. Die beiden Stromquellen bestehen jeweils aus einem npn-Transistor T44 bzw. T43. Schließlich sind Basis und Kollektor des Transistors T13 miteinander gekoppelt.

Die beiden Ansteuerstufen sind identisch aufgebaut und bestehen jeweils aus zwei steuerbaren Stromquellen, die zwischen das negative Versorgungspotential GND und die gekoppelten Emitter der Transistoren T1,T2 bzw. T3,T4 geschaltet sind. Die Stromquellen bestehen jeweils aus einem npn-Transistor T37 bis T40, die jeweils kollektorseitig mit den gekoppelten Emittern der Transistoren T3,T4 bzw. T1,T2 verschaltet sind und die emitterseitig über jeweils einen Widerstand R20 bis R23 mit dem negativen Versorgungspotential GND verbunden sind. Transistoren T15 und T26, deren Basen als Steuereingänge FMO und FTU vorgesehen sind,sind über ihre Kollektoren an das positive Versorgungspotential VCC angeschlossen. Die Basen zweier Transistoren T16 und T27, deren Kollektoren an das positive Versorgungspotential VCC angeschlossen sind, liegen an einem Abgriff zwischen den Widerständen R11 und R12. Die Emitter der Transistoren T15, T16, T26 und T27 sind jeweils über eine Stromquelle mit dem negativen Versorgungspotential GND verbunden. Die Stromquellen bestehen wiederum aus npn-Transistoren T53, T52, T48, T47, die emitterseitig über jeweils einen Widerstand R32, R31, R28, R25, an das negative Versorgungspotential GND gelegt sind. Ihre Kollektoren sind jeweils mit den zugeordneten Transistoren T15, T16, T26, T27 verbunden. Jeweils zwei npn-Transistoren T17, T18 bzw. T28, T29, deren Kollektoren paarweise gekoppelt und mit dem positiven Versorgungspotential VCC verbunden sind, sind jeweils emitterseitig mit den Basen der Transistoren T37 bis T40 verbunden. Jeweils ein npn-Transistor T19 bzw. T30 ist über seinen Kollektor mit der Basis und über seine Basis mit dem Emitter des Transistors T17 bzw. T28 gekoppelt. Entsprechend ist ein npn-Transistor T20 bzw. T31 über seinen Kollektor an der Basis und über seine Basis an den Emitter des Transistors T18 bzw. T29 angeschlossen. Schließlich sind jeweils pnp-Transistoren T21, T22 bzw. T32 und T33, deren Emitter jeweils an ein Hilfspotential H1, H2, H3, H4 angeschlossen sind und deren Basen mit den Emittern der Transistoren T15, T16, T26, T27 verbunden sind, kollektorseitig mit den Basen der Transistoren T17, T18, T28, T29 verbunden. Dabei sind zwischen das negative Versorgungspotential GND und die Emitter der Transistoren T19, T20, T30, T31 jeweils Widerstände R14, R15, R27, R26 gestaltet.

In Weiterbildung der Erfindung sind bei beiden Ansteuerstufen pnp-Transistoren T23 und T24 bzw. T34 und T35 vorgesehen, deren Emitter mit dem positiven Versorgungspotential VCC und deren Basen jeweils miteinander verbunden sind, wobei der Kollektor des Transistors T24 bzw. T25 mit der Basis des Transistors T15 bzw. T26 gekoppelt ist. Die Basis eines npn-Transistors T25 bzw. T36, dessen Kollektor mit dem positiven Versorgungspotential VCC verbunden ist, ist an den Kollektor sowie der Basis des Transistors T23 bzw. T34 angeschlossen. Der Emitter des Transistors T25 bzw. T36 ist über jeweils eine Stromquelle an das negative Versorgungspotential GND angeschlossen. Die Stromquellen werden hierbei durch jeweils einen npn-Transistor T53 bzw. T50 gebildet. Die zusätzliche Anordnung mit den Transistoren T23, T24, T25, T54 bzw. T34, T35, T36, T50 bewirkt, daß der Basisstrom der Transistoren T15 bzw. T26 nahezu vollständig kompensiert wird.

Zudem ist eine der beiden Ansteuerstufen mittels eines Widerstandes R16 gegengekoppelt. Dazu ist der Widerstand R16 zwischen die Basen der Transistoren T15 und T16 geschaltet. Die gegengekoppelte Ansteuerstufe wird mit einem Signal FMO, das an die Basis des Transistors T15 geführt ist, angesteuert. Das Signal FMO dient zur Frequenzmodulation des Oszillators. Dagegen wird die nichtgegengekoppelte Ansteuerstufe mit einem Signal FTU beaufschlagt, das an die Basis des Transistors T26 gelegt ist. Das Signal FTU dient zum Abgleich der Oszillatorstufe.

In Ausgestaltung der Erfindung sind neben Ausgangssignalen A1 und A2, die an den Emittern der Transistoren T5 und T6 abgenommen werden, weitere Ausgangssignale A3 und A4 vorgesehen, die an den Kollektoren der Transistoren T7 und T8 abgenommen werden. Dazu sind zwischen das positive Versorgungspotential VCC und die Kollektoren der Transistoren T7 und T8 jeweils Widerstände R17 und R18 geschaltet. Die zueinander symmetrischen Ausgangssignale A3 und A4 sind dabei beipielsweise zur Ansteuerung eines nachgeschalteten Frequenzteilers vorgesehen. In diesem Zusammenhang sei daraufhingewiesen, für den Fall, daß ein unsymmetrisches Signal benötigt wird, nur eines der beiden Ausgangssignale A3 und A4 zu verwenden ist. In diesem Fall kann auf einen der beiden Widerstände R17 und R18 verzichtet werden und der Kollektor des jeweiligen Transistors T7 oder T8 direkt an das positive Versorgungspotential VCC gelegt werden. Die mittels Emitterfolger, bestehend aus den Transistoren T5, T42, R24 bzw. T6, T41 und R19, gepufferten Ausgangssignale A1 und A2 sind beispielsweise zur Ansteuerung einer Sendeendstufe vorgesehen.

Die einzelnen Stromquellen sind zu insgesamt drei Strombänken zusammengefaßt. Eine Strombank weist einen npn-Transistor T56 auf, dessen Kollektor an dem positiven Versorgungspotential VCC angeschlossen ist und dessen Basis mit einem Biaspotential B1 beaufschlagt ist. Ein npn-Transistor T55, dessen Emitter über einen Widerstand R34 mit dem negativen Versorgungspotential GND verbunden ist, ist zum einen kollektorseitig mit der Basis des Transistors T56 und basisseitig mit dem Emitter des Transistors T56 sowie mit den Basen der Transistoren T52, T53 und T54 gekoppelt. Die zweite Strombank weist einen npn-Transistor T49 auf, dessen Kollektor an das positive Versorgungspotential VCC angeschlossen ist und dessen Basis mit einem Biaspotential B2 beaufschlagt ist. Ein npn-Transistor T51, dessen Emitter über einen Widerstand R30 mit dem negativen Versorgungspotential GND verbunden ist, ist kollektorseitig mit der Basis des Transistors T49 und basisseitig mit dem Emitter des Transistors T49 sowie mit den Basen der Transistoren T41, T42, T47, T48 und T50 verbunden. Die dritte Strombank besteht aus einem kollektorseitig mit dem positiven Versorgungspotential VCC verbundenen npn-Transistor T45, dessen Basis an ein Biaspotential B3 angeschlossen ist. Der Kollektor eines emitterseitig an dem negativen Versorgungspotential GND liegenden npn-Transistors T46 ist mit der Basis des Transistors T45 verbunden. Die Basis des Transistors T46 ist zum einen mit dem Emitter des Transistors T45 und zum anderen über einen Widerstand R35 mit den Basen der Transistoren T43 und T44 gekoppelt.

Abschließend sei daraufhingewiesen, daß neben bipolaren Ausgestaltungen der erfindungsgemäßen Oszillatorschaltung - wie im Ausführungsbeispiel gezeigt - in gleicher Weise aber auch MOS-Ausführungen möglich sind.

## Patentansprüche

1. Oszillatorschaltung bestehend aus einer Oszillatorstufe
mit einem ersten und zweiten Transistor (T1, T2) des einen Leitungstyps, deren Emitter miteinander gekoppelt sind,
mit einem dritten und vierten Transistor (T3, T4) des einen Leitungstyps, deren Emitter miteinander gekoppelt sind,
mit einem fünften Transistor (T5) des einen Leitungstyps, dessen Emitter mit den gekoppelten Basen von erstem und drittem Transistor (T1, T3) sowie dessen Kollektor mit einem ersten Versorgungspotential (VCC) verbunden ist und dessen Basis als ein Anschluß für ein frequenzbestimmendes Rückkopplungsglied (L, C1) vorgesehen ist,
mit einem sechsten Transistor (T6) des einen Leitungstyps, dessen Emitter mit den gekoppelten Basen von zweitem und viertem Transistor (T2, T4) sowie dessen Kollektor mit einem ersten Versorgungspotential (VCC) verbunden ist und dessen Basis als ein anderer Anschluß für das frequenzbestimmende Rückkopplungsglied (L, C1) vorgesehen ist,
mit einem ersten, zweiten, dritten, vierten und fünften Widerstand (R1, R2, R3, R4, R5), die jeweils zwischen die Kollektoren von drittem und viertem Transistor (T3, T4), zwischen die Basis des fünften Transistors (T5) und den Kollektor des vierten Transistors (T4), zwischen die Basis des fünften Transistors (T5) und den Kollektor des zweiten Transistors (T2), zwischen die Basis des sechsten Transistors (T6) und den Kollektor des dritten Transistors (T3) sowie zwischen die Basis des sechsten Transistors (T6) und den Kollektor des ersten Transistors (T1) geschaltet sind, dadurch gekennzeichnet, daß die schaltung weite ausgestaltet ist
mit einem siebten und achten Transistor (T7, T8) des einen Leitungstyps, deren Kollektoren mit dem ersten Versorgungspotential (VCC) verbunden sind,
mit einem sechsten und siebten Widerstand (R6, R7), die zwischen den Emitter des siebten Transistors (T7) und den Kollektor des ersten bzw. dritten Transistors (T1, T3) geschaltet sind,
mit einem achten und neunten Widerstand (R8, R9), die zwischen den Emitter des achten Transistors (T8) und den Kollektor des zweiten bzw. vierten Transistors (T2, T4) geschaltet sind,
mit einer ersten und zweiten Stromquelle (T42, R24, T41, R19), die zwischen ein zweites Versorgungspotential (GND) und den Emitter des fünften bzw. sechsten Transistors (T5, T6) geschaltet sind,
mit einem neunten Transistor (T9) des einen Leitungstyps, dessen Kollektor mit dem ersten Versorgungspotential (VCC) und dessen Basis mit den Basen von siebtem und achtem Transistor (T7, T8) verbunden sind,
mit einem zehnten Widerstand (R10), der zwischen das erste Versorgungspotential (VCC) und die Basis des neunten Transistors (T9) geschaltet ist,
mit einem zehnten Transistor (T10) des einen Leitungstyps, dessen Kollektor mit der Basis des neunten Transistors (T9) und dessen Emitter mit dem zweiten Versorgungspotential (GND) verbunden ist,
mit einem elften, zwölften und dreizehnten Widerstand (R11, R12, R13), die in Reihe zwischen den Emitter des neunten Transistors (T9) und das zweite Versorgungspotential (GND) geschaltet sind,
mit einem elften und zwölften Transistor (T11, T12) des einen Leitungstyps, deren gekoppelte kollektoren mit dem ersten Versorgungspotential (VCC) verbunden sind und deren Basen an ein erstes Biaspotential (B4) bzw. an einen Abgriff zwischen zwölftem und dreizehntem Widerstand (R12, R13) angeschlossen sind,
mit einem dreizehnten und vierzehnten Transistor (T13, T14) des anderen Leitungstyps, deren Emitter jeweils mit den Emittern von elftem und zwölftem Transistor (T11, T12) verbunden sind, wobei Basis und kollektor des dreizehnten Transistors verbunden sind,
und
mit einer dritten und vierten Stromquelle (T44, T43), die zwischen das zweite Versorgungspotential (GND) und den Kollektor des dreizehnten Transistors (T13) bzw. des vierzehnten Transistors (T14) geschaltet sind, wobei die Basis des zehnten Transistors (T10) mit dem kollektor des vierzehnten Transistors verbunden ist,
und mit mindestens einer Ansteuerstufe mit einer ersten und zweiten steuerbaren Stromquelle (T39, R22, T40, R23; T37, R20, T38, R21) die zwischen das zweite Versorgungspotential (GND) und die gekoppelten Emitter von erstem und zweitem bzw. drittem und viertem Transistor (T1, T2; T3, T4) geschaltet sind,
mit einem fünfzehnten Transistor (T15; T26) des einen Leitungstyps, dessen Kollektor an das erste Versorgungspotential (VCC) angeschlossen ist und dessen Basis als Signaleingang (FMO; FTU) vorgesehen ist, mit einem sechzehnten Transistor (T16; T27) des einen Leitungstyps, dessen Kollektor an das erste Versorgungspotential (VCC) und dessen Basis an einen Abgriff zwischen elftem und zwölftem Widerstand (R11, R12) angeschlossen ist, mit einer fünften und sechsten Stromquelle (T53, R32, T52, R31; T48, R28, T47, R25), die zwischen das erste Betriebspotential (GND) und den Emitter des fünfzehnten bzw. sechzehnten Transistors (T15, T16; T26, T27) geschaltet sind,
mit einem siebzehnten und achtzehnten Transistor (T17, T18; T28, T29) des einen Leitungstyps, deren gekoppelte Kollektoren mit dem ersten Versorgungspotential (VCC) und deren Emitter jeweils mit einem Steuereingang der ersten bzw. zweiten steuerbaren Stromquelle (T40, R22, T37, R20; T39, R22, T38, R21) verbunden ist,
mit einem neunzehnten Transistor (T19, T30) des einen Leitungstyps, dessen Kollektor mit der Basis des siebzehnten Transistors und dessen Basis mit dem Emitter des siebzehnten Transistors (T17, T28) verbunden ist,
mit einem zwanzigsten Transistor (T20, T31) des einen Leitungstyps, dessen Kollektor mit der Basis des achtzehnten Transistors und dessen Basis mit dem Emitter des achtzehnten Transistors (T18; T29) verbunden ist,
mit einem einundzwanzigsten und zweiundzwanzigsten Transistor (T21, T22, T32, T33) des anderen Leitungstyps, deren Emitter jeweils an ein Hilfspotential (H1, H2, H3, H4) angeschlossen sind, deren Basen mit den Emitter des fünfzehnten bzw. sechzehnten Transistors (T15, T16; T26, T27) und deren Kollektoren mit der Basis des siebzehnten bzw. achtzehnten Transistors (T17, T18; T28, T29) verbunden sind und mit einem vierzehnten und fünfzehnten Widerstand (R14, R15; R27, R26), die zwischen das zweite Versorgungspotential (GND) und dem Emitter des neunzehnten bzw. zwanzigsten Transistor (T19, T20; T30, T31) geschaltet sind.

2. Oszillatorschaltung nach Anspruch 1,
**gekennzeichnet durch** mindestens einen dreiundzwanzigsten und vierundzwanzigsten Transistor (T23, T24; T34, T35) des anderen Leitungstyps; deren Emitter mit dem ersten Versorgungspotential (VCC) und deren Basen miteinander verbunden sind, wobei der Kollektor des vierundzwanzigsten Transistors (T24; T35) mit der Basis des fünfzehnten Transistors (T15, T26) gekoppelt ist,
durch einen fünfundzwanzigsten Transistor (T25; T36) des einen Leitungstyps, dessen Kollektor mit dem ersten Versorgungspotential (VCC) und dessen Basis mit dem Kollektor sowie der Basis des dreiundzwanzigsten Transistors (T23; T34) verbunden ist, und durch eine siebte Stromquelle (T54; T50), die zwischen den Emitter des fünfundzwanzigsten Transistors (T25; T36) und das zweite Versorgungspotential (GND) geschaltet ist.

3. Schaltungsanordnung nach Anspruch 1 oder 2,
**dadurch gekennzeichnet**,
daß bei einer Ansteuerstufe die Basen des fünfzehnten und sechzehnten Transistors (T15, T16) mittels eines sechzehnten Widerstandes (R16) miteinander gekoppelt sind.

4. Schaltungsanordnung nach einem der Ansprüche 1 bis 3,
**dadurch gekennzeichnet**,
daß die Kollektoren von siebtem und/oder achtem Transistor (T7, T8) über einen siebzehnten bzw. achtzehnten Widerstand mit dem ersten Versorgungspotential verbunden sind.

5. Schaltungsanordnung nach einem der Ansprüche 1 bis 4,
**dadurch gekennzeichnet** , daß die erste bis siebte Stromquelle zu mindestens einer Strombank zusammengefaßt sind.

## Claims

1. Oscillator circuit comprising an oscillator stage having a first and second transistor (T1, T2) of the one conduction type whose emitters are coupled to one another, having a third and fourth transistor (T3, T4) of the one conduction type whose emitters are coupled to one another, having a fifth transistor (T5) of the one conduction type whose emitter is connected to the coupled bases of first and third transistor (T1, T3) and whose collector is connected to a first supply potential (VCC) and whose base is provided as a connection for a frequency-determining feedback member (L, C1), having a sixth transistor (T6) of the one conduction type whose emitter is connected to the coupled bases of second and fourth transistor (T2, T4) and whose collector is connected to a first supply potential (VCC) and whose base is provided as another connection for the frequency-determining feedback member (L, C1), having a first, second, third, fourth and fifth resistor (R1, R2, R3, R4, R5) which are connected in each case between the collectors of third and fourth transistor (T3, T4), between the base of the fifth transistor (T5) and the collector of the fourth transistor (T4), between the base of the fifth transistor (T5) and the collector of the second transistor (T2), between the base of the sixth transistor (T6) and the collector of the third transistor (T3) as well as between the base of the sixth transistor (T6) and the collector of the first transistor (T1), characterized in that the circuit is furthermore configured with a seventh and eighth transistor (T7, T8) of the one conduction type whose collectors are connected to the first supply potential (VCC), with a sixth and seventh resistor (R6, R7) which are connected between the emitter of the seventh transistor (T7) and the collector of the first and third transistor (T1, T3), respectively, with an eighth and ninth resistor (R8, R9) which are connected between the emitter of the eighth transistor (T8) and the collector of the second and fourth transistor (T2, T4), respectively, with a first and second current source (T42, R24, T41, R19) which are connected between a second supply potential (GND) and the emitter of the fifth and sixth transistor (T5, T6), respectively, with a ninth transistor (T9) of the one conduction type whose collector is connected to the first supply potential (VCC) and whose base is connected to the bases of seventh and eighth transistor (T7, T8), with a tenth resistor (R10) which is connected between the first supply potential (VCC) and the base of the ninth transistor (T9), with a tenth transistor (T10) of the one conduction type whose collector is connected to the base of the ninth transistor (T9) and whose emitter is connected to the second supply potential (CND), with an eleventh, twelfth and thirteenth resistor (R11, R12, R13) which are connected in series between the emitter of the ninth transistor (T9) and the second supply potential (GND), with an eleventh and twelfth transistor (T11, T12) of the one conduction type whose coupled collectors are connected to the first supply potential (VCC) and whose bases are connected to a first bias potential (B4) and, respectively, to a tap between twelfth and thirteenth resistor (R12, R13), with a thirteenth and fourteenth transistor (T13, T14) of the other conduction type whose emitters are connected in each case to the emitters of eleventh and twelfth transistor (T11, T12), base and collector of the thirteenth transistor being connected, and with a third and fourth current source (T44, T43) which are connected between the second supply potential (GND) and the collector of the thirteenth transistor (T13) and of the fourteenth transistor (T14) , respectively the base of the tenth transistor (T10) being connected to the collector of the fourteenth transistor, and with at least one driving stage having a first and second controllable current source (T39, R22, T40, R23; T37, R20, T38, R21) which are connected between the second supply potential (GND) and the coupled emitters of first and second and, respectively, third and fourth transistor (T1, T2; T3, T4), with a fifteenth transistor (T15; T26) of the one conduction type whose collector is connected to the first supply potential (VCC) and whose base is provided as signal input (FMO; FTU), with a sixteenth transistor (T16; T27) of the one conduction type whose collector is connected to the first supply potential (VCC) and whose base is connected to a tap between eleventh and twelfth resistor (R11, R12), with a fifth and sixth current source (T53, R32, T52, R31; T48, R28, T47, R25) which are connected between the first operating potential (CND) and the emitter of the fifteenth and sixteenth transistor (T15, T16; T26, T27), respectively, with a seventeenth and eighteenth transistor (T17, T18; T28, T29) of the one conduction type whose coupled collectors are connected to the first supply potential (VCC) and whose emitters are connected in each case to a control input of the first and, respectively, second controllable current source (T40, R22, T37, R20; T39, R22, T38, R21), with a nineteenth transistor (T19, T30) of the one conduction type whose collector is connected to the base of the seventeenth transistor and whose base is connected to the emitter of the seventeenth transistor (T17, T28), with a twentieth transistor (T20, T31) of the one conduction type whose collector is connected to the base of the eighteenth transistor and whose base is connected to the emitter of the eighteenth transistor (T18; T29), with a twenty-first and twenty-second transistor (T21, T22, T32, T33) of the other conduction type whose emitters are connected in each case to an auxiliary potential (H1, H2, H3, H4) and whose bases are connected to the emitter of the fifteenth and sixteenth transistor (T15, T16; T26, T27), respectively, and whose collectors are connected to the base of the seventeenth and eighteenth transistor (T17, T18; T28, T29), respectively, and with a fourteenth and fifteenth resistor (R14, R15; R27, R26) which are connected between the second supply potential (GND) and the emitter of the nineteenth and twentieth transistor (T19, T20; T30, T31), respectively.

2. Oscillator circuit according to Claim 1, characterized by at least one twenty-third and twenty-fourth transistor (T23, T24; T34, T35) of the other conduction type; whose emitters are connected to the first supply potential (VCC) and whose bases are connected to each other, the collector of the twenty-fourth transistor (T24; T35) being coupled to the base of the fifteenth transistor (T15, T26), by a twenty-fifth transistor (T25; T36) of the one conduction type whose collector is connected to the first supply potential (VCC) and whose base is connected to the collector as well as to the base of the twenty-third transistor (T23; T34), and by a seventh current source (T54; T50) which is connected between the emitter of the twenty-fifth transistor (T25; T36) and the second supply potential (GND).

3. Circuit arrangement according to Claim 1 or 2, characterized in that in a driving stage, the bases of the fifteenth and sixteenth transistor (T15, T16) are coupled to one another by means of a sixteenth resistor (R16).

4. Circuit arrangement according to one of Claims 1 to 3, characterized in that the collectors of seventh and/or eighth transistor (T7, T8) are connected to the first supply potential via a seventeenth and eighteenth resistor, respectively.

5. Circuit arrangement according to one of Claims 1 to 4, characterized in that the first to seventh current sources are combined to form at least one current bank.

## Revendications

1. Circuit oscillateur constitué d'un étage oscillateur comportant
des premier et second transistors (T1,T2) d'un premier type de conductivité et dont les émetteurs sont reliés entre eux, des troisième et quatrième transistors (T3,T4) possédant le premier type de conductivité et dont les émetteurs sont reliés entre eux,
un cinquième transistor (T2) du premier type de conductivité, dont l'émetteur est relié aux bases reliées entre elles des premier et troisième transistors (T1,T3), dont le collecteur est relié à un premier potentiel d'alimentation (VCC) et dont la base est prévue en tant que borne pour un circuit de réaction (L,C1), qui détermine la fréquence,
un sixième transistor (T6) du premier type de conductivité, dont l'émetteur est relié aux bases reliées entre elles des second et quatrième transistors (T2,T4), dont le collecteur est relié à un premier potentiel d'alimentation (VCC) et dont la base est prévue en tant qu'autre borne pour le circuit de réaction (L,C1) qui détermine la fréquence,
des première, seconde, troisième, quatrième et cinquième résistances (R1,R2,R3,R4,R5), qui sont branchées respectivement entre les collecteurs des troisième et quatrième transistors (T3,T4), entre la base du cinquième transistor (T5) et le collecteur du quatrième transistor (T4), entre la base du cinquième transistor (T5) et le collecteur du second transistor (T2), entre la base du sixième transistor (T6) et le collecteur du troisième transistor (T3) ainsi qu'entre la base du sixième transistor (T6) et le collecteur du premier transistor (T1),
caractérisé par le fait que le circuit comporte en outre des septième et huitième transistors (T7,T8) du premier type de conductivité et dont les collecteurs sont reliés au premier potentiel d'alimentation (VCC),
des sixième et septième résistances (R6,R7), qui sont branchées entre l'émetteur du septième transistor (T7) et le collecteur du premier ou troisième transistor (T1,T3), des huitième et neuvième résistances (R8,R9), qui sont branchées entre l'émetteur du huitième transistor (T8) et le collecteur du second ou quatrième transistor (T2, T4),
des première et seconde sources de courant (T42,R24,T41,R19), qui sont branchées entre un second potentiel d'alimentation (GND) et l'émetteur du cinquième ou sixième transistor (T5, T6),
un neuvième transistor (T9) du premier type de conductivité, dont le collecteur est relié au premier potentiel d'alimentation (VCC) et dont la base est reliée aux bases des septième et huitième transistors (T7, T8),
une dixième résistance (R10), qui est branchée entre le premier potentiel d'alimentation (VCC) et la base du neuvième transistor (T9),
un dixième transistor (T10) du premier type de conductivité, dont le collecteur est relié à la base du neuvième transistor (T9) et dont l'émetteur est relié au second potentiel d'alimentation (GND),
des onzième, douzième et treizième résistances (R11,R12,R13), qui sont branchées en série entre l'émetteur du neuvième transistor (T9) et le second potentiel d'alimentation (GND), des onzième et douzième transistors (Tll,T12) du premier type de conductivité, dont les collecteurs reliés entre eux sont reliés au premier potentiel d'alimentation (VCC) et dont les bases sont raccordées à un premier potentiel de polarisation (B4) ou à une prise située entre les douzième et treizième résistances (R12, R13),
des treizième et quatorzième transistors (T13, T14) de l'autre type de conductivité, dont les émetteurs sont reliés respectivement aux émetteurs des onzième et douzième transistors (T11,T12), la base et le collecteur du treizième transistor étant reliés entre eux, et
des troisième et quatrième sources de courant (T44, T43), qui sont branchées entre le second potentiel d'alimentation (GND) et le collecteur du treizième transistor (T13) ou du quatorzième transistor (T14), la base du dixième transistor (T10) étant reliée au collecteur du quatorzième transistor, et
au moins un étage de commande comportant des première et seconde sources de courant commandables (T39, R22, T40, R23; T37, R20, T38, R21), qui sont branchées entre le second potentiel d'alimentation (GND) et les émetteurs reliés entre eux des premier et second ou des troisième et quatrième transistors (T1, T2; T3,T4),
un quinzième transistor (T15; T26) du premier type de conductivité, dont le collecteur est raccordé au premier potentiel d'alimentation (VCC) et dont la base est prévue en tant qu'entrée de signal (FMO; FTU), un seizième transistor (T16; T27) du premier type de conductivité, dont le collecteur est raccordé au premier potentiel d'alimentation (VCC) et dont la base est raccordée à une prise située entre les onzième et douzième résistances (R11, R12), des cinquième et sixième sources de courant (T53, R32, T52, R31; T48, R28, T47, R25) qui sont branchées entre le premier potentiel de fonctionnement (GND) et l'émetteur du quinzième ou seizième transistor (T15,T16; T26,T27), des dix-septième et dix-huitième transistors (T17, T18, T28, T29) du premier type de conductivité, dont les collecteurs reliés entre eux sont reliés au premier potentiel d'alimentation (VCC) et dont les émetteurs sont reliés respectivement à une entrée de commande des première ou seconde sources de courant commandables (T40, R22, T37, R20; T39, R22, T38, R21), un dix-neuvième transistor (T19, T30) du premier type de conductivité, dont le collecteur est relié à la base du dix-septième transistor et dont la base est reliée à l'émetteur du dix-septième transistor (T17, T28), un vingtième transistor (T20, T31) du premier type de conductivité, dont le collecteur est relié à la base du dix-huitième transistor et dont la base est reliée à l'émetteur du dix-huitième transistor (T18; T29), des vingt-et-unième et vingt-deuxième transistors (T21, T22, T32, T33) de l'autre type de conductivité, dont les émetteurs sont raccordés respectivement à un potentiel auxiliaire (H1, H2, H3, H4), dont les bases sont raccordées à l'émetteur du quinzième ou seizième transistor (T15,T16; T26,T27) et dont les collecteurs sont reliés à la base du dix-septième ou dix-huitième transistor (T17,T19; T28,T29), et des quatorzième et quinzième résistances (R14,R15; R27,R28) qui sont branchées entre le second potentiel d'alimentation (GND) et l'émetteur du dix-neuvième ou vingtième transistor (T19, T20; T30, T31).

2. Circuit oscillateur suivant la revendication 1, caractérisé
par au moins des vingt-troisième et vingt-quatrième transistors (T23,T24; T34,T35) de l'autre type de conductivité, dont les émetteurs sont reliés au premier potentiel d'alimentation (VCC) et dont les bases sont reliées entre elles, le collecteur du vingt-quatrième transistor (T24; T35) étant relié à la base du quinzième transistor (T15,T26),
par un vingt-cinquième transistor (T25;T36) du premier type de conductivité, dont le collecteur est relié au premier potentiel d'alimentation (VCC) et dont la base est reliée au collecteur ainsi qu'à la base du vingt-troisième transistor (T23;T34), et
par une septième source de courant (T54; T50), qui est branchée entre les émetteurs du vingt-cinquième transistor (T25;T36) et le second potentiel d'alimentation (GND).

3. Circuit oscillateur suivant la revendication 1 ou 2, caractérisé par le fait que dans un étage de commande, les bases des quinzième et seizième transistors (T15,T16) sont reliées entre elles au moyen d'une seizième résistance (R16).

4. Circuit oscillateur suivant l'une des revendications 1 à 3, caractérisé par le fait que les collecteurs du septième et/ou du huitième transistor (T7,T8) sont reliés au premier potentiel d'alimentation par l'intermédiaire d'une dix-septième ou d'une dix-huitième résistance.

5. Circuit oscillateur suivant l'une des revendications 1 à 4, caractérisé par le fait que les sept premières sources de courant sont rassemblées pour former au moins un bloc d'alimentation en courant.
